(19) Europäisches Patentamt
European Patent Office
Office européen des brevets

(11) **EP 2 278 354 B1**

(12) **EUROPÄISCHE PATENTSCHRIFT**

(45) Veröffentlichungstag und Bekanntmachung des Hinweises auf die Patenterteilung:
**29.07.2015  Patentblatt 2015/31**

(51) Int Cl.:
***G01S 7/02*** *(2006.01)*

(21) Anmeldenummer: **10004886.7**

(22) Anmeldetag: **07.05.2010**

(54) **Verfahren und Vorrichtung zur Ermittlung von periodischen Signalanteilen**

Method and device for determining periodic signal sections

Procédé et dispositif destinés à la détermination de parties de signaux périodiques

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **20.07.2009  DE 102009033952**
**12.10.2009  DE 102009049060**

(43) Veröffentlichungstag der Anmeldung:
**26.01.2011  Patentblatt 2011/04**

(73) Patentinhaber: **Rohde & Schwarz GmbH & Co. KG**
**81671 München (DE)**

(72) Erfinder: **Robelly, Pablo  Dr.**
**Edificio Baviera, Dpto. 103, Quito-Ecuador (EC)**

(74) Vertreter: **Körfer, Thomas et al**
**Mitscherlich PartmbB**
**Patent- und Rechtsanwälte**
**Postfach 33 06 09**
**80066 München (DE)**

(56) Entgegenhaltungen:
**DE-C1- 19 822 957     KR-A- 20080 021 326**
**US-B1- 6 335 701**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft ein Verfahren und eine Vorrichtung zur Ermittlung von periodischen Signalanteilen, insbesondere in einem Radarsignal.

Radarsignale enthalten periodische Signalanteile, die entweder eine diskrete Signalform, sogenannte Pulssignale, oder eine kontinuierliche Signalform, sogenannte Continuous-Wave-(CW)-Signale, aufweisen. Für die Überwachung und Analyse von Radarsignalen ist die Identifizierung dieser periodischen Signalanteile im typischerweise verrauschten Empfangssignal ganz wesentlich. Die Identifizierung periodischer Signalanteile im Radarsignal beruht auf der Ermittlung einer Periodizität, d.h. auf der Ermittlung der Periodendauer der aus mehreren Periodizitätszyklen bestehenden periodischen Signalanteile im empfangenen Radarsignal.

Für den Fall eines Pulssignals werden hierzu gemäß Nishiguchi K. et al.: "Improved Algorithm for Estimating Pulse Repetition Intervals", IEEE Transactions on Aerospace and Electronic Systems, Vol. 36, No. 2, April 2000, Seiten 407-421, die Flanken und deren Ankunftszeiten ermittelt, um anschließend über eine statistische Auswertung der einzelnen Ankunftszeiten mittels eines sogenannten $\Delta T$-Diagramms die Periodendauer des pulsförmigen Radarsignals zu ermitteln.

Das Verfahren ist aber nachteilig nur für pulsförmige Radarsignale geeignet und scheidet bei periodischen Signalanteilen mit kontinuierlicher Signalform - periodische CW-Signale - leider aus.

Die US 6 335 701 B1 beschreibt ein Verfahren zur Ermittlung der Geschwindigkeit eines sich bewegenden Objektes auf der Basis einer Radarmessung. Im Hinblick auf einen besseren Signal-Rausch-Abstand des zu ermittelnden Radarsignals wird für jeden einzelnen empfangenen Impuls des Radarsignals ein Leistungsdichtespektrum ermittelt und anschließend sämtliche Leistungsdichtespektren kohärent summiert.

Die KR 2008 0021326 A offenbart die Bestimmung eines Leistungsdichtespektrums eines Zeitsignals mittels zweifacher Fourier-Transformation. Eine Messung einer Periodendauer einer Grundwelle in einem Radarsignal mittels Ermittlung der invertierten Frequenz des ermittelten Leistungsdichtespektrums der im Radarsignal enthaltenen Grundwelle geht aus diesem Dokument nicht hervor.

Die DE 198 22 957 C1 offenbart ein Verfahren zur Detektion und Unterdrückung von Störsignalen in einem empfangenen Radarsignal. Eine Messung einer Periodendauer einer Grundwelle in einem Radarsignal mittels Ermittlung der invertierten Frequenz des ermittelten Leistungsdichtespektrums der im Radarsignal enthaltenen Grundwelle geht somit aus diesem Dokument nicht hervor. Das Dokument offenbart hierbei die Ermittlung des Leistungsdichtespektrums des empfangenen Radarsignals inklusive des überlagerten Störsignals mittels einer einzigen Fourier-Transformation. Die Bestimmung eines Leistungsdichtespektrums mittels zweifacher Fourier-Transformation geht aus diesem Dokument ebenfalls nicht hervor.

Aufgabe der Erfindung ist es deshalb, ein Verfahren und eine Vorrichtung zur Detektion von periodischen Signalanteilen in Radarsignalen zu schaffen, die sowohl eine diskrete als auch eine kontinuierliche Signalform aufweisen können.

Die Erfindungsaufgabe wird durch ein Verfahren zur Ermittlung von periodischen Signalanteilen mit diskreter und/oder kontinuierlicher Signalform in einem empfangenen Radarsignal mit den Merkmalen des Patentanspruchs 1 und durch eine Vorrichtung zur Ermittlung von periodischen Signalanteilen mit diskreter und/oder kontinuierlicher Signalform in einem empfangenen Radarsignal mit den Merkmalen des Patentanspruchs 6 gelöst. Vorteilhafte technische Erweiterungen sind in den abhängigen Patentansprüchen aufgeführt.

Um auch periodische Signalanteile mit kontinuierlicher Signalform zu identifizieren, erfolgt die Ermittlung der Periodizität im Frequenzbereich, indem anstelle einer Ermittlung der Autokorrelationsfunktion des empfangenen Radarsignals, die die Erstellung des $\Delta T$-diagramms systemtheoretisch beschreibt, die Fourier-Transformierte der Autokorrelationsfunktion des empfangenen Radarsignals, die das Leistungsdichtespektrum des empfangenen Radarsignals darstellt, ermittelt wird. Durch bevorzugte Inversion der Frequenzen der im Leistungsdichtespektrum enthaltenen Grundwellen erhält man die Periodendauer der zugehörigen periodischen Signalanteile.

Um die Frequenzen der Unterwellen aus dem Leistungsdichtespektrum zu eliminieren, wird das ermittelte Leistungsdichtespektrum bevorzugt einer zyklischen Autokorrelation unterzogen.

Um das Leistungsdichtespektrum des empfangenen Radarsignals über einen Beobachtungszeitraum von N Abtastwerten des empfangenen Radarsignals möglichst effizient durchzuführen, wird vorzugsweise eine zweifache Fourier-Transformation durchgeführt. Im ersten Schritt werden anstelle einer Fourier-Transformation über N Abtastwerte des empfangenen Radarsignals eine P-fache Fourier-Transformation über jeweils N' Abtastwerte des empfangenen Radarsignals durchgeführt. Auf diese Weise entsteht ein Spektrogramm mit jeweils P Zeitpunkten zugeordneten Spektren, die aus jeweils N' Abtastwerten des empfangenen Radarsignals hervorgehen und jeweils N' Spektralwerte enthalten. Die einzelnen Elemente eines derart ermittelten Spektrogramms werden im zweiten Schritt mit den jeweils korrespondierenden Elementen eines dazu konjugiert-komplexen Spektrogramms zu Spektralwerten eines Leistungsdichtespektrogramms multipliziert. Schließlich werden in einem dritten Schritt die Spektralwerte des Leistungsdichtespektrogramms mit einem identischen Frequenzstützpunkt aus allen P Leistungsdichtespektren jeweils einer zweiten Fournier-Transformation unterzogen.

Um sowohl die "Vorgeschichte" als auch die "Nachgeschichte" eines Signalereignisses im empfangenen Radarsignal bei der Berechnung des Spektrogramms besser zu berücksichtigen, werden die einzelnen P Spektren des Spektrogramms vorzugsweise überlappend in einem bestimmten Überlappungsbereich ermittelt. Zusätzlich werden die Abtastwerte des empfangenen Radarsignals insbesondere im Überlappungsbereich mittels Fensterung entsprechend dem Verlauf der verwendeten Fensterfunktion gewichtet.

Um die Frequenzen der Oberwellen aus dem ermittelten Leistungsdichtespektrum zu eliminieren, wird in Analogie zum Zeitbereich das ermittelte Leistungsdichtespektrum einer zyklischen Autokorrelation unterzogen.

Ausführungsbeispiele des erfindungsgemäßen Verfahrens und der erfindungsgemäßen Vorrichtung zur Ermittlung von periodischen Signalanteilen mit diskreter oder kontinuierlicher Signalform in einem empfangenen Radarsignal werden im Folgenden anhand der Zeichnung im Detail erläutert. Die Figuren der Zeichnung zeigen:

Fig. 1     ein Blockdiagramm einer bisher üblichen Vorrichtung zur Ermittlung von periodischen Signalanteilen im empfangenen Radarsignal,

Fig. 2     ein Blockdiagramm einer erfindungsgemäßen Vorrichtung zur Ermittlung von periodischen Signalanteilen im empfangenen Radarsignal,

Fig. 3     ein Flussdiagramm eines erfindungsgemäßen Verfahrens zur Ermittlung von periodischen Signalanteilen im empfangenen Radarsignal,

Fig. 4A     ein Zeitdiagramm mit den Ankunftszeiten der zu einer Pulsfolge jeweils gehörigen Flanken,

Fig. 4B     ein Zeitdiagramm eines $\Delta T$-Histogramms,

Fig. 4C     ein Zeitdiagramm eines Terms einer Autokorrelationsfunktion mit grundfrequenten und unterfrequenten Autokorrelationsanteilen,

Fig. 4D     ein Frequenzdiagramm mit dem Linienspektrum des Leistungsdichtespektrums und

Fig. 5     eine schematische Darstellung einer überlappenden Fourier-Transformation.

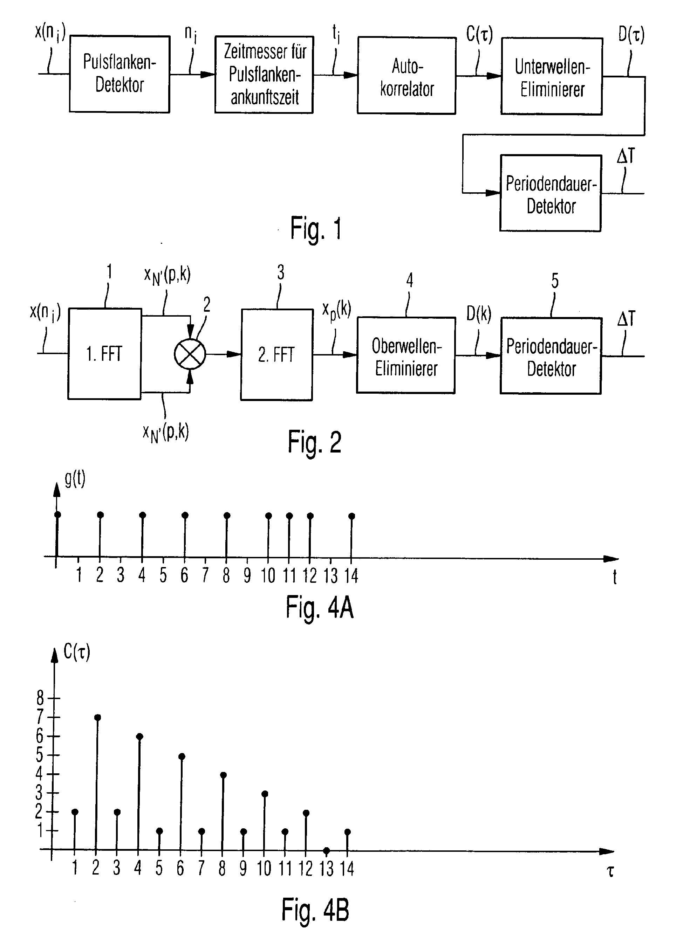

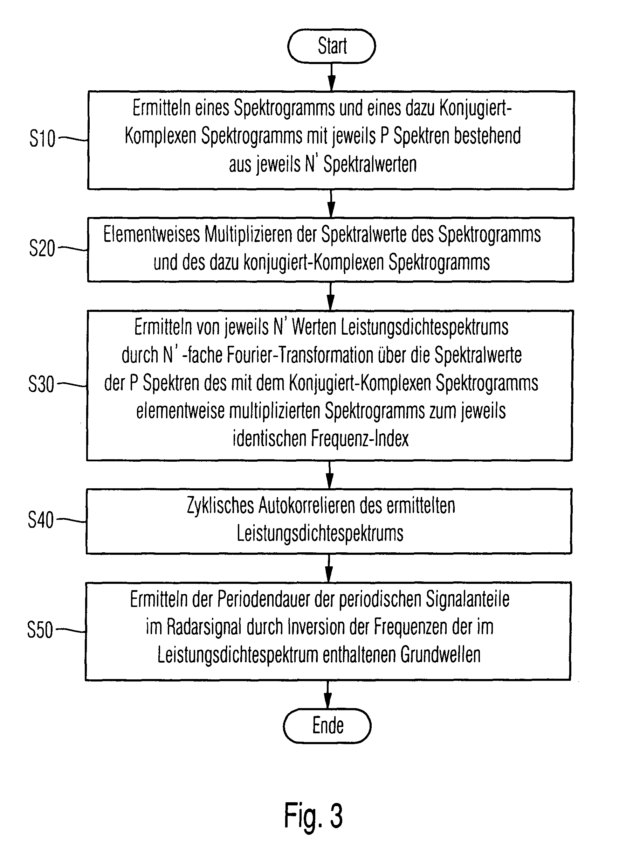

Bevor das erfindungsgemäße Verfahren und die erfindungsgemäße Vorrichtung zur Ermittlung von periodischen Signalanteilen im empfangenen Radarsignal anhand der Figuren 2 und 3 beschrieben werden, werden im Folgenden die für das Verständnis der Erfindung erforderlichen mathematischen Grundlagen hergeleitet. Hierzu werden zuerst die mathematischen Grundlagen des bislang bei der Anmelderin üblichen Verfahrens bei der Ermittlung von periodischen Signalanteilen mit diskreter Signalform im empfangenen Radarsignal hergeleitet und anhand von Fig. 1 veranschaulicht.

Die Detektion der Pulse des periodischen Signalanteils im empfangenen Radarsignal beinhaltet die Detektion der einzelnen Flanken - entweder steigende oder fallende Flanken - des Pulssignals $x(n_i)$ und deren Ankunftszeiten $t_i$. Die Ankunftszeiten $t_i$ der zu insgesamt $N$ Pulsen $x(n_i)$ gehörenden Flanken kann gemäß Gleichung (1) als Summe von Dirac-Impulsen zu den einzelnen Ankunftszeiten $t_i$ modelliert werden.

$$g(t) = \sum_{i=0}^{N-1} \delta(t - t_i) \qquad\qquad (1)$$

Die Auswertung der einzelnen Ankunftszeiten $t_i$ kann die Ermittlung der Zeitintervalle $\Delta T_i = t_i - t_{i-1}$ zwischen jeweils zwei aufeinander folgenden Ankunftszeiten $t_i$ und $t_{i-1}$ beinhalten oder, was im Folgenden weiterverfolgt wird, die Ermittlung der Zeitintervalle $\Delta T_{ij} = t_i - t_j$ zwischen sämtlichen Ankunftszeiten $t_i$ und $t_j$ (mit $i \neq j$; $i=0,..., N$-2; $j=1,....N$-1) und die Zählung der Anzahl von zu jedem Wert von zu $\Delta T_i$ bzw. von zu $\Delta T_{ij}$ jeweils ermittelten Zeitintervallen in einem Histogramm. Diese zweite Variante der Auswertung von Zeitintervallen $\Delta T_{ij}$ wird als $\Delta T$-Histogramm bezeichnet. Die Ermittlung eines derartigen $\Delta T$-Histogramms mit der Anzahl gezählter Zeitintervalle $\Delta T_{ij}$ kann systemtheoretisch gemäß Gleichung (2) als Autokorrelation der Dirac-Impulssumme gemäß Gleichung (1) interpretiert werden, wobei die Variable $\tau$ in Gleichung (2) der Größe des Zeitintervalls $\Delta T_{ij}$ zwischen den Ankunftszeiten von zu zwei Pulsen jeweils gehörigen Flanken entspricht.

$$C(\tau) = \int_{-\infty}^{+\infty} g(t) \cdot g(t+\tau) dt \qquad\qquad\qquad (2)$$

Setzt man die Beziehung für die Dirac-Implussumme $g(t)$ aus Gleichung (1) in Gleichung (2) ein, so ergibt sich für das Autokorrelationsergebnis $C(\tau)$ die Beziehung in Gleichung (3).

$$C(\tau) = \sum_{i=1}^{N-1} \sum_{l=0}^{i-1} \delta(t - t_i - t_l) \qquad\qquad\qquad (3)$$

Bei einer beispielhaften Pulssignalfolge mit den zu den einzelnen Pulsen gehörigen Ankunftszeiten gemäß Fig. 4A, ergibt sich ein $\Delta T$-Histogramm gemäß Fig. 4B. Das Autokorrelationsergebnis gemäß Gleichung (2) und Fig. 4B weist den Nachteil auf, dass in Abhängigkeit der Variable $\tau$, die einem Zeitintervall $\Delta T_{ij}$ des $\Delta T$-histogramm entspricht, nicht nur Autokorrelationsanteile bei der Grundfrequenz, sondern auch Autokorrelationsanteile bei Unterfrequenzen enthalten sind. Die Grundfrequenz der Grundwelle entspricht dabei dem invertierten Zeitintervall $\dfrac{1}{\tau}$, während sich die Unterfrequenzen der Unterwellen aus den invertierten Zeitintervallen $\dfrac{1}{2\tau}$, $\dfrac{1}{3\tau}$, $\dfrac{1}{4\tau}$ usw. ergeben.

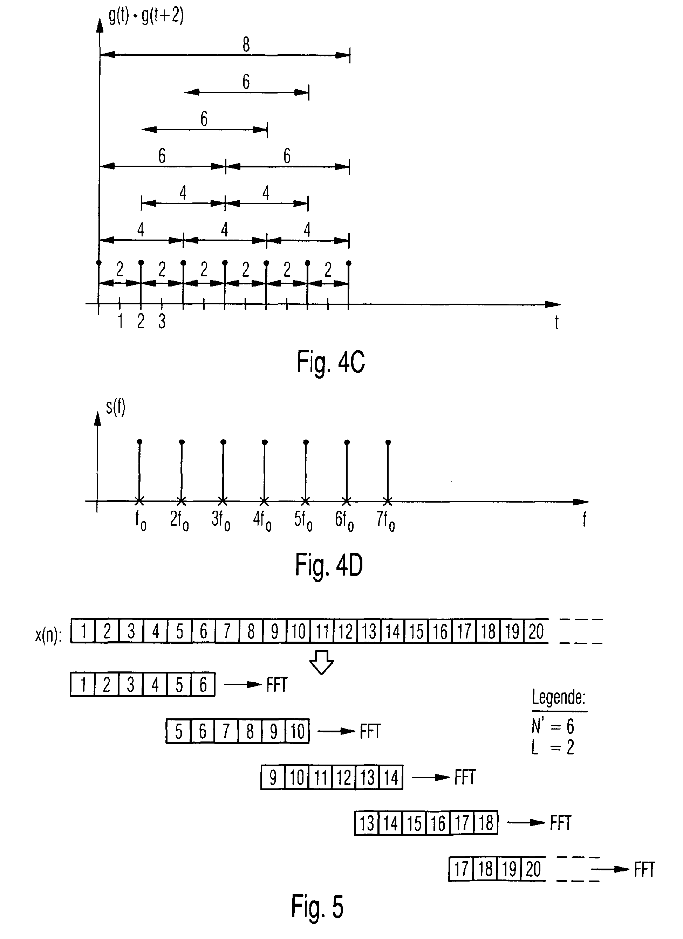

Dies ist in Fig. 4C für die der Variable $\tau$=2 entsprechenden Autokorrelationsanteile $g(t) \cdot g(t+2)$ aufgezeigt. Zu erkennen ist, dass sich die der Variable $\tau$ = 2 entsprechenden Autokorrelationsanteile $g(t) \cdot g(t+2)$ aus Autokorrelationsanteilen der Grundfrequenz $\dfrac{1}{\tau} = \dfrac{1}{2}$ und aus Autokorrelationsanteilen der Unterfrequenzen $\dfrac{1}{2\tau} = \dfrac{1}{4}$, $\dfrac{1}{3\tau} = \dfrac{1}{6}$ und $\dfrac{1}{4\tau} = \dfrac{1}{8}$ zusammensetzen. Zur Beseitigung der störenden Autokorrelationsanteile mit Unterfrequenzen, wird die Autokorrelation der Dirac-Impulssumme gemäß Gleichung (2) durch eine zyklische Autokorrelation der Dirac-Impulssumme gemäß Gleichung (4) ersetzt, bei der einzig der der Grundfrequenz entsprechende Autokorrelationsanteil einen Beitrag zum Autokorrelationsergebnis liefert, während die den Unterfrequenzen entsprechenden Autokorrelationsanteile sich zu Null mitteln.

$$D(\tau) = \int_{-\infty}^{+\infty} g(t) \cdot g(t+\tau) \cdot e^{j2\pi \cdot \frac{t}{\tau}} dt \qquad\qquad\qquad (4)$$

Setzt man die Beziehung für die Dirac-Impulssumme $g(t)$ aus Gleichung (1) in Gleichung (4) ein, so ergibt sich für das Autokorrelationsergebnis $D(\tau)$ die Beziehung in Gleichung (5).

$$D(\tau) = \sum_{i=1}^{N-1} \sum_{l=0}^{i-1} \delta(t - t_i + t_l) \cdot e^{j2\pi \cdot \frac{t_i}{t_i - t_l}} \qquad\qquad\qquad (5)$$

Die Periodendauern $\tau_i$ der periodischen Signalanteile im empfangenen Radarsignal ergeben sich aus den Maximas des zyklischen Autokorrelationsergebnisses $D(\tau)$.

Besteht das empfangene Radarsignal nicht nur aus periodischen Signalanteilen mit einer diskreten Signalform, sondern auch aus periodischen Signalanteilen mit einer kontinuierlichen Signalform, so ist eine auf der Detektion der Ankunftszeiten der einzelnen Pulsflanken basierende Vorgehensweise nicht mehr zielführend. Anstelle einer Betrachtung, die auf einzelne Zeitpunkte - hier auf die Ankunftszeiten der einzelnen Pulsflanken - konzentriert ist, ist eine Betrachtung vorzusehen, die auf Zeitbereiche - hier auf den Signalverlauf $x(t)$ eines kontinuierlichen periodischen Signalanteils - erweitert ist. In Anlehnung an das Autokorrelationsergebnis $C(\tau)$ der Gleichung (2) für den Fall einer diskreten Signalform ergibt sich für den Fall, der auch kontinuierliche Signalformen einschließt, ein Autokorrelationsergebnis $s(\tau)$ gemäß Gleichung (6).

$$s(\tau) = \int_{-\infty}^{+\infty} x(t) \cdot x(t + \tau) dt \qquad (6)$$

Im Gegensatz zu Gleichung (3) für den vereinfachten Fall einer diskreten Signalform ist das Autokorrelationsergebnis für den Fall, dass auch kontinuierliche Signalformen mitberücksichtigt werden müssen, gemäß Gleichung (6) algorithmisch nicht einfach zu lösen. Eine deutliche algorithmische Vereinfachung ergibt sich durch eine erfindungsgemäße Transformation in den Frequenzbereich. Die zur Autokorrelationsfunktion $s(\tau)$ in Gleichung (6) korrespondierende Fourier-Transformierte $S(f)$ lässt sich gemäß Gleichung (7) als Produkt der Spektralfunktion $X(f)$ und der konjugiert-komplexen Spektralfunktion $X^*(f)$ des empfangenen Radarsignals $x(t)$ berechnen und entspricht dem Leistungsdich-tespektrum.

$$S(f) = X(f) \cdot X^{\bullet}(f) \qquad (7)$$

Die zur analogen Spektralfunktion $X(f)$ des empfangenen Radarsignals $x(t)$ korrespondierende diskrete Spektralfunktion $X_N(k)$ lässt sich gemäß Gleichung (8) aus der Fast-Fourier-Transformation des zeit-diskreten empfangenen Radarsignals $x(n)$ über einen Beobachtungszeitraum von insgesamt $N$ Abtastwerten des zeit-diskreten empfangenen Radarsignals $x(n)$ berechnen.

$$X_N(k) = \sum_{n=0}^{N-1} x(n) \cdot e^{-j2\pi kn/N} \qquad (8)$$

Um die Komplexität der schnellen Fast-Fourier-Transformation (FFT) aufgrund der hohen Anzahl N von Abtastwerten des zeit-diskreten empfangenen Radarsignals $x(n)$ zu reduzieren, werden in einer ersten Fast-Fourier-Transformation gemäß Gleichung (9) anstelle von N Abtastwerten des zeit-diskreten empfangenen Radarsignals $x(n)$ lediglich N' Abtastwerte des zeit-diskreten empfangenen Radarsignals $x(n)$ in jeweils P sequentiell ablaufenden Spektralberechnungen benutzt, wobei $N=N' \cdot P$ ist.

$$X_{N'}(p,k) = \sum_{n=p}^{p+N'-1} x(n) \cdot e^{-j2\pi kn/N'} \quad \text{mit} \quad p = 0,...,P-1 \qquad (9)$$

Auf diese Weise ist ein Spektrogramm bestehend aus insgesamt P Spektren zu jeweiligen Zeitpunkten $p=0,...,P-1$ bestehend aus jeweils insgesamt N' Spektralwerten $X_{N'}(p,k)$ zu den einzelnen Frequenzstützpunkten $k=0,...,N'-1$ ermittelt worden.

Alternativ können in der ersten Fourier-Transformation gemäß Gleichung (10) die Spektralwerte $X_{N'}(p,k)$ des Spektrogramms aus Abtastwerten des zeitdiskreten empfangenen Radarsignals $x(n)$ berechnet werden, die einen Überlappungsbereich von jeweils $L$ Abtastwerten aufweisen, wie in Fig. 5 schematisch dargestellt ist. Die Anzahl von Abtastwerten des zeitdiskreten empfangenen Radarsignals $x(n)$ gehen in insgesamt P Spektren zu den jeweiligen Zeitpunkten $p=0,...,P-1$ ein, wobei $P = \dfrac{N}{L}$ und die Anzahl N der Abtastwerte sich von der Anzahl L sich überlappender Abtastwerte um ein Vielfaches des Faktors 2 unterscheiden ($N=2_n \cdot L, n=1,2,3...$ ).

$$X_{N'}(p,k) = \sum_{m=p}^{N'-1+p} w(m-p) \cdot x(L \cdot p + m - p) \cdot e^{-j2\pi k(m-p)/N'}$$
$$\text{mit} \quad p = 0,...,P-1 \qquad (10)$$

In Gleichung (10) ist eine Fensterfunktion $w(\cdot)$ eingeführt, die die für die Berechnung des jeweiligen Spektrums innerhalb des Spektrogramms benötigten Abtastwerte des zeit-diskreten empfangenen Radarsignals $x(n)$ selektiert und insbesondere eine Gewichtung der Abtastwerte des zeit-diskreten empfangenen Radarsignals $x(n)$ in den Überlappungsbereichen bewirkt. Als Fensterfunktion $w(\cdot)$ können geeignete gängige Fensterfunktionen, beispielsweise Gauss-, Hann-, Tschebyscheff-Fenster usw., verwendet werden.

Daraufhin erfolgt gemäß Gleichung (11) eine elementweise Multiplikation jedes Spektralwerts $X_{N'}(p,k)$ des Spektrogramms $X_{N'}$ mit dem korrespondierenden Spektralwert $X_{N'}^*(p,k)$ des dazu konjungiert-komplexen Spektrogramms $X_{N'}^*$ zu einem Spektralwert $Y_{N'}(p,k)$ eines Leistungsdichtespektrogramms $Y_{N'}$.

$$Y_{N'}(p,k) = X_{N'}(p,k) \otimes X_{N'}^*(p,k) \qquad (11)$$

In einer zweiten Fast-Fourier-Transformation wird gemäß Gleichung (12) für jedes Paar von Frequenzstützpunkten $r=0,...,P\text{-}1$ und $k=0,...,N'\text{-}1$ jeweils ein Spektralwert $X_P(r,k)$ eines Leistungsdichtespektrums $X_p$ aus den Spektralwerten $Y_{N'}(p,k)$ im Leistungsdichtespektrogramm $Y_{N'}$ in allen Zeitpunkten $p=0,...,P\text{-}1$ des jeweiligen Frequenzstützpunktes $k=0,...,N'\text{-}1$ berechnet.

$$X_P(r,k) = \sum_{p=0}^{P-1} Y_{N'}(p,k) \cdot e^{-j2\pi rp/P} \qquad (12)$$

Das Leistungsdichtespektrum $Y_{N'}$ stellt eine Matrix mit den Spektralwerten $Y_{N'}(p,k)$ zu den einzelnen Paaren von Frequenzstützpunkten $r=0,...,P\text{-}1$ und $k=0,...,N'\text{-}1$ dar. Um das Leistungsdichtespektrum $X_P(k)$ zu den einzelnen Frequenzstützpunkten $k=0,...,N'\text{-}1$ als vektorielle Größe zu gewinnen, wird gemäß Gleichung (13) beispielsweise für jeden Frequenzstützpunkt $k=0,...,N'\text{-}1$ der jeweilige maximale Spektralwert $X_P(r,k)$ des Leistungsdichtespektrums $X_P(k)$ über alle Frequenzstützpunkte $r=0,...,P\text{-}1$ ermittelt.

$$X_P(k) = \underset{r=0,...,P-1}{Max}\left\{X_P(r,k)\right\} \qquad (13)$$

Da das empfangene Radarsignal $x(t)$ periodische Signalanteile aufweist, die aus einer Grundwelle mit oder ohne Oberwellen bestehen, weist auch die Autokorrelationsfunktion $s(\tau)$ gemäß Gleichung (6) periodische Anteile aus einer Grundwelle mit oder ohne Oberwellen auf. Das zugehörige Spektrum $S(f)$, das gemäß Gleichung (8) das Leistungsdichtespektrum des empfangenen Radarsignals $x(t)$ darstellt, besteht folglich gemäß Fig. 4D aus einem Linienspektrum mit einer Spektrallinie bei der Grundfrequenz und zusätzlichen Spektrallinien bei den Höherharmonischen.
Falls mehrere periodische Signalteile im empfangenen Radarsignal $x(t)$ vorhanden sind, ist es für den Betrachter sehr schwierig die einzelnen Grundwellen bzw. ihre Grundfrequenzen von den Höherharmonischen und deren Oberfrequenzen voneinander zu unterscheiden. Um die Oberwellenspektrallinien aus dem Autokorrelationsergebnis auszublenden, wird in Analogie zum Zeitbereich auf die ermittelten Spektralwerte $X_P(k)$ des Leistungsdichtespektrums gemäß Gleichung (14) eine zyklische Autokorrelationsfunktion $D(k)$ ermittelt.

$$D(k) = \sum_{k=0}^{N'-1} X_P(k) \cdot X_P^*(k+\zeta) \cdot e^{j2\pi k/\zeta} \qquad (14)$$

Die Periodendauer $\tau_i$ der periodischen Signalanteile im empfangenen Radarsignal $x(t)$ ergeben sich aus den inversen Grundfrequenzen der in der Autokorrelationsfunktion $D(k)$ verbliebenen, zu den jeweiligen Grundwellen gehörigen Spektrallinien.
Das erfindungsgemäße Verfahren zur Ermittlung von periodischen Signalanteilen mit diskreter oder kontinuierlicher Signalform in einem empfangenen Radarsignal beginnt gemäß dem Flussdiagramm in Fig. 3 im Verfahrensschritt S10 mit der Ermittlung der einzelnen Spektralwerte $X_{N'}(p,k)$ in den einzelnen Frequenzstützpunkten $k=0,...,N'\text{-}1$ und zu den einzelnen Zeitpunkten $p=0,...,P\text{-}1$, die jeweils zu einem der insgesamt P Spektren des Spektrogramms gehören, und der einzelnen dazu konjugiert-komplexen Spektralwerte $X_{N'}^*(p,k)$, die jeweils zu einem der insgesamt P Spektren des entsprechend konjugiert-komplexen Spektrogramms gehören, in einem ersten Fast-Fourier-Transformator 1 in Fig. 2 aus den einzelnen Abtastwerten des empfangenen Radarsignals $x(t)$. Diese Spektralwerte $X_{N'}(p,k)$ bzw. die dazu konjugiert-komplexen Spektralwerte $X_{N'}^*(p,k)$ ergeben sich für den Fall einer überlappungsfreien Fast-Fourier-Transformation gemäß Gleichung (9) und für den Fall einer überlappungsbehafteten Fast-Fourier-Transformation gemäß Gleichung (10).
Im nächsten Verfahrensschritt S20 werden die einzelnen Spektralwerte $X_{N'}(p,k)$ des ermittelten Spektrogramms $X_{N'}$ und die einzelnen konjugiert-komplexen Spektralwerte $X_{N'}^*(p,k)$ des konjugiert-komplexen Spektrogramms $X_{N'}^*$ elementweise gemäß Gleichung (11) in einem Multiplizierer 2 miteinander zu einem Spektralwert $Y_{N'}(p,k)$ eines Leistungsdichtespektrogramms $Y_{N'}$ multipliziert.

In einem zweiten Fast-Fourier-Transformator 3 werden im darauffolgenden Verfahrensschritt S30 die insgesamt $N'·P$ Werte $X_P(r,k)$ des Leistungsdichtespektrums $X_P$ zum jeweiligen Paar von Frequenzstützpunkten $r=0,...,P-1$ und $k=0,...,N'-1$ aus den Spektralwerten $Y_{N'}(p,k)$ des Leistungsdichtespektrogramms $Y_{N'}$ zu allen Zeitpunkten $p=0,...,P-1$ im jeweiligen Frequenzstützpunkt $k=0,...,N'-1$ mittels Fast-Fourier-Transformation gemäß Gleichung (12) berechnet. Um ein vektorielles Leistungsdichtespektrum $X_P$ zu gewinnen, wird für jeden Frequenzstützpunkt $k=0,...,N'-1$ jeweils beispielsweise der maximale Spektralwert $X_P(r,k)$ in allen Frequenzstützpunkten $r=0,1,...,P-1$ des jeweiligen Frequenzstützpunktes $k=0,...,N'-1$ aus dem Leistungsdichtespektrums $X_P$ in Matrixform gemäß Gleichung (13) ermittelt.

Im darauffolgenden Verfahrensschritt S40 erfolgt in einer Funktionseinheit 4 zur Eliminierung von Oberwellen die Eliminierung sämtlicher höher harmonischen Linienspektren des Leistungsdichtespektrums mittels zyklischer Autokorrelationsfunktion $D(k)$ gemäß Gleichung (14).

Schließlich werden im abschließenden Verfahrensschritt S50 aus den verbliebenen Spektrallinien des Leistungsdichtespektrums, die zu den Grundwellen des Leistungsdichtespektrums gehören, die zugehörigen Grundfrequenzen $f_i$ ermittelt und durch Inversion der ermittelten Grundfrequenzen $f_i$ die zugehörigen Periodendauern $\tau_i$ in einem Periodendauer-Detektor 5 bestimmt, die die Periodendauern der einzelnen periodischen Signalanteile mit diskreter und/oder kontinuierlicher Signalform im empfangenen Radarsignal $x(t)$ darstellen.

Die Erfindung ist nicht auf die dargestellte Ausführungsform des erfindungsgemäßen Verfahrens und der erfindungsgemäßen Vorrichtung zur Ermittlung von periodischen Signalanteilen mit diskreter oder kontinuierlicher Signalform in einem empfangenen Radarsignal beschränkt. Von der Erfindung sind neben der zyklischen Autokorrelation auch andere Verfahren zur Eliminierung von Oberwellen in einem Linienspektrum abgedeckt.

## Patentansprüche

1. Verfahren zur Ermittlung von periodischen Signalanteilen mit diskreter und/oder kontinuierlicher Signalform in einem empfangenen Radarsignal (x(t)), welches folgende Verfahrensschritte umfasst:

   • Ermitteln von Spektralwerten ($X_{N'}(p,k)$) und von konjugiert-komplexen Spektralwerten ($X_{N'}*(p,k)$) in jeweils mehreren Spektren eines Spektrogramms ($X_{N'}$) mittels eines ersten Fourier-Transformators (1),
   • Multiplizieren der einzelnen Spektralwerte ($X_{N'}(p,k)$) mit den korrespondierenden konjugiert-komplexen Spektralwerten ($X_{N'}*(p,k)$) zu jeweils einem Spektralwert ($Y_{N'}(p,k)$) in jeweils mehreren Spektren eines Leistungsdichtespektrums ($Y_{N'}$) mittels eines Multiplizierers (2),
   • Ermitteln von Spektralwerten ($X_P(k)$) eines Leistungsdichtespektrums ($X_P$) mittels eines zweiten Fourier-Transformators (2) und
   • Eliminieren von Oberwellenspektrallinien aus dem Leistungsdichtespektrum ($X_P$) mittels einer Funktionseinheit (4) zur Eliminierung von Oberwellenspektrallinien aus dem Leistungsdichtespektrum, wobei zur Ermittlung der periodischen Signalanteile ein zum empfangenen Radarsignal gehöriges Leistungsdichtespektrum mittels P-facher Fourier-Transformation ermittelt wird, so dass anstelle einer Fourier-Transformation über N Abtastwerte des empfangenen Radarsignals eine P-fache Fourier-Transformation über jeweils N' Abtastwerte des empfangenen Radarsignals durchgeführt wird und auf diese Weise ein Spektrogramm mit jeweils P Zeitpunkten zugeordneten Spektren, die aus jeweils N' Abtastwerten des empfangenen Radarsignals hervorgehen und jeweils N' Spektralwerte enthalten, entsteht, wobei N = N'·P ist.

2. Verfahren nach Anspruch 1,
   **dadurch gekennzeichnet,**
   **dass** die invertierte Frequenz der im Leistungsdichtespektrum ($X_P$) jeweils enthaltenen Grundwellen der Periodendauer des zugehörigen periodischen Signalanteils entspricht.

3. Verfahren nach Anspruch 1 oder 2,
   **dadurch gekennzeichnet,**
   **dass** das Ermitteln von Spektralwerten ($X_P(k)$) des Leistungsdichtespektrums ($X_P$) mittels einer zweiten Fourier-Transformation aus den Spektralwerten ($Y_{N'}(p,k)$) eines Leistungsdichtespektrogramms ($Y_{N'}$) in jedem Zeitpunkt ($p$) und im jeweiligen Frequenzstützpunkt ($k$) erfolgt.

4. Verfahren nach Anspruch 3,
   **dadurch gekennzeichnet,**
   **dass** die ermittelten Spektren des Spektrogramms ($X_{N'}(p,k)$) und des konjugiert-komplexen Spektrogramms

$(X_{N'}*(p,k))$ sich überlappen.

**5.** Verfahren nach Anspruch 3 oder 4,
**dadurch gekennzeichnet,**
**dass** zur Ermittlung der einzelnen Spektren des Spektrogramms und des konjugiert-komplexen Spektrogramms die zugehörigen Abtastwerte des empfangenen Radarsignals einer Fensterung mit einer bestimmten Fensterfunktion $(w(\cdot))$ unterzogen werden.

**6.** Vorrichtung zur Ermittlung von periodischen Signalanteilen mit diskreter und/oder kontinuierlicher Signalform in einem empfangenen Radarsignal $(x(t))$ mit einem ersten Fourier-Transformator (1) zur Ermittlung von Spektralwerten $(X_{N'}(p,k))$ und konjugiert-komplexen Spektralwerten $(X_{N'}*(p,k))$ in jeweils mehreren Spektren eines Spektrogramms $(X_{N'})$,
einem Multiplizierer (2) zur Multiplikation der einzelnen Spektralwerte $(X_{N'}(p,k))$ mit den korrespondierenden konjugiert-komplexen Spektralwerten $(X_{N'}*(p,k))$ zu jeweils einem Spektralwert $(Y_{N'}(p,k))$ in jeweils mehreren Spektren eines Leistungsdichtespektrogramms $(Y_{N'})$,
einem zweiten Fourier-Transformator (3) zur Ermittlung von Spektralwerten $(X_P(k))$ eines Leistungsdichtespektrums $(X_P)$, und
eine dem zweiten Fourier-Transformator (3) nachgeschaltete Funktionseinheit (4) zur Eliminierung von Oberwellenspektrallinien aus dem Leistungsdichtespektrum, wobei die Vorrichtung so ausgebildet ist, dass zur Ermittlung der periodischen Signalanteile ein zum empfangenen Radarsignal gehöriges Leistungsdichtespektrum mittels P-facher Fourier-Transformation ermittelt wird, so dass anstelle einer Fourier-Transformation über N Abtastwerte des empfangenen Radarsignals eine P-fache Fourier-Transformation über jeweils N' Abtastwerte des empfangenen Radarsignals durchgeführt wird und auf diese Weise ein Spektrogramm mit jeweils P Zeitpunkten zugeordneten Spektren, die aus jeweils N' Abtastwerten des empfangenen Radarsignals hervorgehen und jeweils N' Spektralwerte enthalten, entsteht,
wobei N = N'·P ist.

**7.** Vorrichtung nach Anspruch 6,
**dadurch gekennzeichnet,**
**dass** zusätzlich ein Periodendauer-Detektor (5) zur Ermittlung von Periodendauern der periodischen Signalanteile aus den Frequenzen von im Leistungsdichtespektrum enthaltenen Grundwellenspektrallinien vorhanden ist.

**Claims**

**1.** Method for determining periodic signal contents with a discrete and/or continuous wave form in a received radar signal $(x(t))$, which comprises the following steps:

- determination of spectral values $(X_{N'}(p, k))$ and of conjugate complex spectral values $(X_{N'}*(p,k))$ in each case in a plurality of spectra of a spectrogram $(X_{N'})$ by means of a first Fourier transformer (1),
- multiplication of the individual spectral values $(X_{N'}(p,k))$ with the corresponding conjugate complex spectral values $(X_{N'}*(p,k))$ to form in each case a spectral value $(Y_{N'}(p,k))$ in each case in a plurality of spectra of a power density spectrum $(Y_{N'})$ by means of a multiplier (2),
- determination of spectral values $(X_p(k))$ of a power density spectrum $(X_p)$ by means of a second Fourier transformer (2) and
- elimination of harmonic spectral lines from the power density spectrum $(X_p)$ by means of a function unit (4) for eliminating harmonic spectral lines from the power density spectrum, wherein to determine the periodic signal contents a power density spectrum belonging to the received radar signal is determined by means of P-fold Fourier transformation so that a P-fold Fourier transformation is carried out in each case using N' sample values of the received radar signal instead of a Fourier transformation using N sample values of the received radar signal and in this way a spectrogram is obtained with in each case spectra which are associated with P points in time and produced from in each case N' sample values of the received radar signal and in each case contain N' spectral values,
wherein N=N'.P.

**2.** Method according to claim 1,
**characterised in that** the inverted frequency of the fundamental waves contained in each case in the power density spectrum $(X_p)$ corresponds to the period of the associated periodic signal content.

3. Method according to claim 1 or 2,
**characterised in that** the determination of spectral values ($Xp(k)$) of the power density spectrum ($Xp$) by means of a second Fourier transformation is effected from the spectral values ($Y_{N'}(p,k)$) of a power density spectrogram ($Y_{N'}$) at each point in time ($p$) and at the respective frequency point ($k$).

4. Method according to claim 3,
**characterised in that** the determined spectra of the spectrogram ($X_{N'}(p,k)$) and of the conjugate complex spectrogram ($X_{N'}*(p,k)$) overlap one another.

5. Method according to claim 3 or 4,
**characterised in that** to determine the individual spectra of the spectrogram and of the conjugate complex spectrogram the associated sample values of the received radar signal are subjected to windowing with a particular window function ($w(*)$).

6. Device for determining periodic signal contents with a discrete and/or continuous wave form in a received radar signal ($x(t)$) with a first Fourier transformer (1) for determining spectral values ($X_{N'}(p,k)$) and conjugate complex spectral values ($X_{N'}*(p,k)$) in each case in a plurality of spectra of a spectrogram ($X_{N'}$),
a multiplier (2) for multiplying the individual spectral values ($X_{N'}(p,k)$) with the corresponding conjugate complex spectral values ($X_{N'}*(p,k)$) to form in each case a spectral value ($Y_{N'}(p,k)$) in each case in a plurality of spectra of a power density spectrogram ($Y_{N'}$),
a second Fourier transformer (3) for determining spectral values ($X_p(k)$) of a power density spectrum ($X_p$), and
a function unit (4) following the second Fourier transformer (3) for eliminating harmonic spectral lines from the power density spectrum, wherein the device is designed so that to determine the periodic signal contents a power density spectrum belonging to the received radar signal is determined by means of P-fold Fourier transformation so that a P-fold Fourier transformation is carried out in each case using N' sample values of the received radar signal instead of a Fourier transformation using N sample values of the received radar signal and in this way a spectrogram is obtained with in each case spectra which are associated with P points in time and produced from in each case N' sample values of the received radar signal and in each case contain N' spectral values,
wherein N = N'. P.

7. Device according to claim 6,
**characterised in that** in addition a period detector (5) is present to determine periods of the periodic signal contents from the frequencies of fundamental wave spectral lines contained in the power density spectrum.

**Revendications**

1. Procédé de détermination de parties de signaux périodiques avec une forme de signal discrète et/ou continue dans un signal radar reçu (x(t)), qui comporte les étapes de procédé suivantes :

• la détermination de valeurs spectrales ($X_{N'}(p, k)$) et de valeurs spectrales conjuguées complexes ($X_{N'}*(p,k)$) dans plusieurs spectres respectifs d'un spectrogramme ($X_{N'}$) au moyen d'un premier transformateur de Fourier (1),
• la multiplication des différentes valeurs spectrales ($X_{N'}(p,k)$) avec des valeurs spectrales conjuguées complexes correspondantes ($X_{N'}\bullet(p,k)$) pour obtenir une valeur spectrale respective ($Y_N(p,k)$) dans plusieurs spectres respectifs d'un spectre de densité de puissance ($Y_{N'}$) au moyen d'un multiplicateur (2),
• la détermination de valeurs spectrales ($X_P(k)$) d'un spectre de densité de puissance ($X_P$) au moyen d'un second transformateur de Fourier (2) et
• l'élimination des lignes spectrales d'harmoniques du spectre de densité de puissance ($X_P$) au moyen d'une unité de fonction (4) pour éliminer les lignes spectrales d'harmoniques du spectre de densité de puissance, dans lequel, en vue de la détermination des parties de signaux périodiques, un spectre de densité de puissance associé au signal radar reçu est déterminé en fonction de P fois la transformée de Fourier, de sorte que, au lieu d'une transformée de Fourier sur les valeurs d'échantillonnage N du signal radar reçu, P fois une transformée de Fourier sur les valeurs d'échantillonnage N' respectives du signal radar reçu sont effectuées et de cette façon il en résulte un spectrogramme avec des spectres associés aux instants P respectifs, qui proviennent des valeurs d'échantillonnage N' respectives du signal radar reçu et contiennent les valeurs spectrales N' respectives,
dans lequel N = N'·P.

**2.** Procédé selon la revendication 1, **caractérisé en ce que**
la fréquence inversée des ondes fondamentales respectives contenues dans le spectre de densité de puissance ($X_P$) correspond à la durée de période de la partie de signal périodique associée.

**3.** Procédé selon la revendication 1 ou 2, **caractérisé en ce que**
la détermination des valeurs spectrales ($X_P(k)$) du spectre de densité de puissance ($X_P$) est effectuée au moyen d'une seconde transformée de Fourier à partir des valeurs spectrales ($Y_{N'}(p,k)$) d'un spectrogramme de densité de puissance ($Y_{N'}$) à chaque instant (p) et à un point de stabilisation de fréquence respective (k).

**4.** Procédé selon la revendication 3, **caractérisé en ce que**
les spectres déterminés du spectrogramme ($X_{N'}(p,k)$) et du spectrogramme conjugué complexe ($X_{N'}{}^{\bullet}(p,k)$) se chevauchent.

**5.** Procédé selon la revendication 3 ou 4, **caractérisé en ce que**,
en vue de la détermination des différents spectres du spectrogramme et du spectrogramme conjugué complexe, les valeurs d'échantillonnage associées du signal radar reçu sont soumises à un fenêtrage avec une fonction de fenêtre déterminée ($w(\bullet)$).

**6.** Dispositif pour déterminer des parties de signal périodiques avec une forme de signal discrète et/ou continue dans un signal radar reçu ($x(t)$) avec un premier transformateur de Fourier (1) en vue de la détermination des valeurs spectrales ($X_{N'}(p,k)$) et des valeurs spectrales conjuguées complexes ($X_{N'}{}^{\bullet}(p,k)$) dans plusieurs spectres respectifs d'un spectrogramme ($X_{N'}$),
un multiplicateur (2) en vue de la multiplication de différentes valeurs spectrales ($X_{N'}(p,k)$) avec les valeurs spectrales conjuguées complexes correspondantes ($X_{N'}{}^{\bullet}(p,k)$) pour obtenir une valeur spectrale respective ($Y_N(p,k)$) dans plusieurs spectres respectifs d'un spectrogramme de densité de puissance ($Y_{N'}$),
un second transformateur de Fourier (3) pour déterminer des valeurs spectrales ($X_P(k)$) d'un spectre de densité de puissance ($X_P$), et
une unité de fonction (4) en aval du second transformateur de Fourier (3) pour éliminer les lignes spectrales d'harmoniques du spectre de densité de puissance,
dans lequel le dispositif est réalisé de sorte que, en vue de la détermination des parties de signal périodiques, un spectre de densité de puissance associé à un signal radar reçu est déterminé en fonction de P fois une transformée de Fourier, de sorte que, au lieu d'une transformée de Fourier sur les valeurs d'échantillonnage N du signal radar reçu, P fois une transformée de Fourier sur les valeurs d'échantillonnage N' respectives du signal radar reçu sont effectuées et de cette manière il en résulte un spectrogramme avec des spectres associés aux instants P respectifs, qui proviennent des valeurs d'échantillonnage N' respectives du signal radar reçu et contiennent les valeurs spectrales N' respectives,
dans lequel $N = N' \cdot P$.

**7.** Dispositif selon la revendication 6, **caractérisé en ce que**
il est prévu de plus un détecteur de durée de période (5) pour déterminer les durées de période des parties de signal périodiques à partir des fréquences des lignes spectrales d'ondes fondamentales contenues dans le spectre de densité de puissance.

x(n$_i$) → | Pulsflanken-Detektor | → n$_i$ → | Zeitmesser für Pulsflankenankunftszeit | → t$_i$ → | Auto-korrelator | → C($\tau$) → | Unterwellen-Eliminierer | → D($\tau$)

| Periodendauer-Detektor | → $\Delta T$

**Fig. 1**

x(n$_i$) → | 1. FFT | (1) → x$_{N'}$(p,k) → ⊗ (2) → | 2. FFT | (3) → x$_p$(k) → | Oberwellen-Eliminierer | (4) → D(k) → | Periodendauer-Detektor | (5) → $\Delta T$

x$_{N'}$(p,k)

**Fig. 2**

g(t)

1 2 3 4 5 6 7 8 9 10 11 12 13 14  t

**Fig. 4A**

C($\tau$)

8 7 6 5 4 3 2 1

1 2 3 4 5 6 7 8 9 10 11 12 13 14  $\tau$

**Fig. 4B**

## Fig. 4C

g(t) · g(t+2)

## Fig. 4D

s(f)

$f_0$  $2f_0$  $3f_0$  $4f_0$  $5f_0$  $6f_0$  $7f_0$

x(n): | 1 | 2 | 3 | 4 | 5 | 6 | 7 | 8 | 9 | 10 | 11 | 12 | 13 | 14 | 15 | 16 | 17 | 18 | 19 | 20 |

| 1 | 2 | 3 | 4 | 5 | 6 | ——► FFT

| 5 | 6 | 7 | 8 | 9 | 10 | ——► FFT

| 9 | 10 | 11 | 12 | 13 | 14 | ——► FFT

| 13 | 14 | 15 | 16 | 17 | 18 | ——► FFT

| 17 | 18 | 19 | 20 | ——► FFT

Legende:
$N' = 6$
$L = 2$

## Fig. 5

```
                    ┌──────────┐
                    │  Start   │
                    └────┬─────┘
                         │
                         ▼
┌──────────────────────────────────────────────────────┐
│   Ermitteln eines Spektrogramms und eines dazu Konjugiert- │
S10 │   Komplexen Spektrogramms mit jeweils P Spektren bestehend │
│           aus jeweils N' Spektralwerten              │
└──────────────────────────────────────────────────────┘
                         │
                         ▼
┌──────────────────────────────────────────────────────┐
│ Elementweises Multiplizieren der Spektralwerte des Spektrogramms │
S20 │        und des dazu konjugiert-Komplexen Spektrogramms      │
└──────────────────────────────────────────────────────┘
                         │
                         ▼
┌──────────────────────────────────────────────────────┐
│     Ermitteln von jeweils N' Werten Leistungsdichtespektrums   │
│   durch N'-fache Fourier-Transformation über die Spektralwerte │
S30 │  der P Spektren des mit dem Konjugiert-Komplexen Spektrogramms │
│     elementweise multiplizierten Spektrogramms zum jeweils   │
│                 identischen Frequenz-Index              │
└──────────────────────────────────────────────────────┘
                         │
                         ▼
┌──────────────────────────────────────────────────────┐
│          Zyklisches Autokorrelieren des ermittelten     │
S40 │                 Leistungsdichtespektrums                │
└──────────────────────────────────────────────────────┘
                         │
                         ▼
┌──────────────────────────────────────────────────────┐
│    Ermitteln der Periodendauer der periodischen Signalanteile │
│        im Radarsignal durch Inversion der Frequenzen der im  │
S50 │      Leistungsdichtespektrum enthaltenen Grundwellen    │
└──────────────────────────────────────────────────────┘
                         │
                         ▼
                    ┌──────────┐
                    │   Ende   │
                    └──────────┘
```

# Fig. 3

**IN DER BESCHREIBUNG AUFGEFÜHRTE DOKUMENTE**

**In der Beschreibung aufgeführte Patentdokumente**

- US 6335701 B1
- KR 20080021326 A
- DE 19822957 C1

**In der Beschreibung aufgeführte Nicht-Patentliteratur**

- **NISHIGUCHI K. et al.** Improved Algorithm for Estimating Pulse Repetition Intervals. *IEEE Transactions on Aerospace and Electronic Systems,* April 2000, vol. 36 (2), 407-421